# EUROPEAN PATENT APPLICATION

(11) **EP 1 647 877 A1**
(43) Date of publication of application: **19.04.2006**
(21) Application number: 05022524.2
(22) Date of filing: 14.10.2005
(51) Int. Cl.: G06F 3/02

(54) **Apparatus and method for detecting key signals in a mobile communication terminal**

(30) Priority: 18.10.2004 KR 2004083210
(71) Applicant: Samsung Electronics Co., Ltd., Suwon-si, Gyeonggi-Do (KR)
(72) Inventor: Kim, Sung-Wan, Yeongtong-gu Suwon-si Gyeonggi-do (KR)
(74) Representative: Grünecker, Kinkeldey, Stockmair & Schwanhäusser Anwaltssozietät

(57) **Abstract**

A method for detecting a key input signal in a mobile communication terminal is disclosed. The terminal has a plurality of keys constituting a key matrix structure with rows, columns, and a switch for connecting one of the rows to one of the columns, and including pull-up resisters for maintaining an input value of each row in the key matrix structure as a 'high' value. The method comprises designating all ports connected to the rows and the columns as input ports; selecting one of a plurality of the columns, changing the selected column into an output port, and outputting a 'low' signal to the output port; scanning the keys; and changing a column selected after the key scan back into an input port.

## Description

The present invention relates generally to a user interface apparatus and method in a mobile communication terminal, and in particular, to an apparatus and method for detecting key input signals in a mobile communication terminal.

A mobile communication terminal has been developed to enable its user to enjoy voice communication regardless of his or her location and movement. With the rapid progress of mobile communication technology, the mobile communication terminal has evolved into an advanced mobile communication terminal capable of providing data service in addition to voice service. Therefore, the user can acquire an increased volume of information using the mobile communication terminal. For example, the user can enjoy various services, such as text messaging, data transmission/reception and games provided over the Intemet using the mobile communication terminal.

In this way, the progress of mobile communication technology contributes to development of mobile communication terminals. For example, in order to transmit/receive a large volume of data, the mobile communication terminal should essentially include a high-capacity memory therein. In addition, the mobile communication terminal requires an interface device for transmitting the large volume of data to another apparatus, for example, a computer. Further, the mobile communication terminal supports a graphic user interface (GUI) in order to enable its user to enjoy various services such as Internet games and E-mail access using the mobile communication terminal. Moreover, there are various interface devices designed to enable the user to input commands to the mobile communication terminal or input text for E-mail.

Typically, a key matrix is used in enabling the user to input commands or texts to the mobile communication terminal. In addition, a touch screen or a touch pad can provide a user interface, but the key matrix is most widely used. Now, a description will be made of the key matrix used as a user interface.

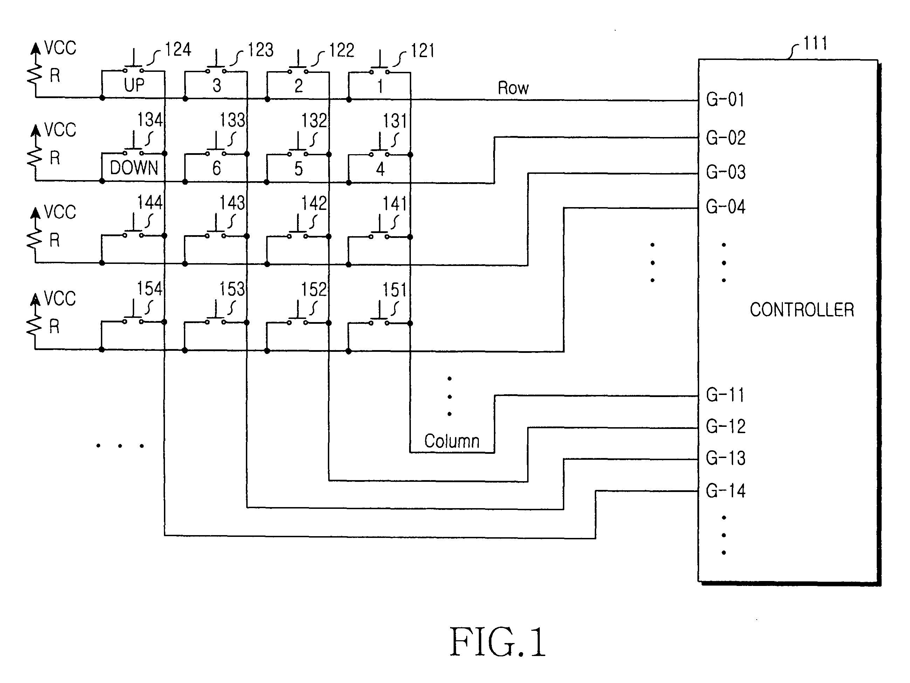

FIG. 1 is a circuit diagram illustrating a key matrix included in a general mobile communication terminal. Referring to FIG. 1, the key matrix can be divided into a key matrix circuit, a controller 111, and a peripheral circuit. The key matrix circuit is comprised of rows, columns, and switches 121 to 154 for connecting the rows to the columns. Each of the switches 121 to 154 connects its row to its column when a user presses a corresponding key on the key matrix of the mobile communication terminal. When the user releases the pressed key, the corresponding switch disconnects its row from its column. For example, the numerals 1, 2, 3, 4, 5, and 6, and the letters UP and DOWN written under the switches 121 to 134 show basic key values that the controller 111 of the mobile communication terminal recognizes when the corresponding switches are pressed by the user.

A detailed description will now be made of the connection between the controller 111 and the key matrix circuit. The controller 111 is generally comprised of a single microprocessor. Further, the controller 111 includes terminals G-01 ··· G-14 ··· for recognizing corresponding key values. The terminals G-01 ··· G-14 ··· for recognizing key values by the controller 111 are commonly implemented with general purpose input/output ports. Rows and columns of the terminals G-01 ··· G-14 ··· are different from each other in operation. A description will be made of the terminals G-01 ... G-14 ···.

The terminals G-01, G-02, G-03 and G-04 connected to the rows are designated as input ports, and their initial values are set to '1'. In order to set the initial values to '1', pull-up resisters R in the respective rows are connected to a power supply terminal Vcc. Because the pull-up resisters R are connected to the power supply terminal Vcc, the corresponding rows normally maintain a High state unless they are connected to the columns, so that the initial values are detected as '1'.

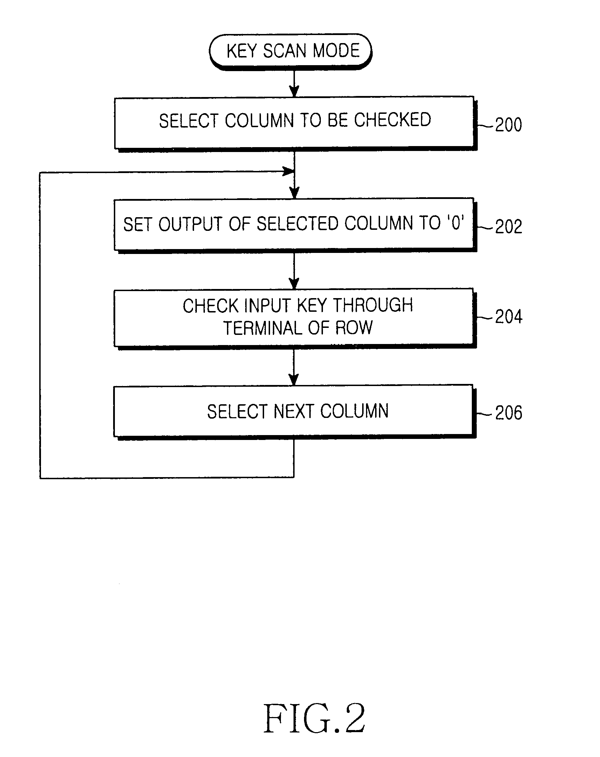

The terminals G-11, G-12, G-13 and G-14 connected to the columns are designated as output ports, and their outputs are set to `1' when no scan is made. Only when it is checked whether there is an input of a specific key, i.e., whether the user presses a specific key, a terminal corresponding to the specific key outputs a value of '0'. The operation of checking whether there is a key input is referred to as a "key scan operation." The key scan operation in the key matrix will now be described in detail with reference to FIG. 2.

FIG. 2 is a flowchart illustrating a key scan operation in a general mobile communication terminal. Referring to FIG. 2, in step 200, the controller 111 selects a column to be checked. The columns can be selected in regular sequence. This will be described with reference to the terminals included in the controller 111. For example, the terminals can be selected in order of G-11 → G-12 → G-13 → G-14 → G-11 → G-12 → ···. After selecting a column to be checked, the controller 111 sets an output of the selected column to '0' in step 202. If it is assumed that the terminal G-11 is selected, a value of '0' is output to the terminal G-11 and a value of '1' is output to the remaining terminals G-12, G-13 and G-14. After changing an output of the selected column to '0', the controller 111 checks in step 204 a row, a value of which is input as a Low value through a terminal of the row, thereby detecting a key value input by the user.

More specifically, when a value of '0' is output via the terminal G-11 as stated above, one of the switches 121, 131, 141 and 151 located in the corresponding column can be input. If the user presses the switch 121 corresponding to the numeral 1, the switch 121 connects its column to its row. Because outputting a value of '0' via the output terminal G-11 means that the output terminal G-11 is grounded, the terminal G-01 is also grounded, changing its value to '0'. That is, while all of the ports G-02, G-03 and G-04 have a High value as input values, the port G-01 receives a Low value. In this manner, the controller 111 can determine a key input value based on a combination of a column of G-11 and a row of G-01.

However, if the user inputs no key or does not input a key of a corresponding column, the controller 111 receives a value of '1' from all of the ports G-01, G-02, G-03 and G-04.

In this method, the controller 111 can detect a key value input by the user through a combination of the corresponding column and row. After performing a key scan operation on one column in this way, the controller 111 performs a key scan operation on the next column in step 206. That is, before scanning the next column, the controller 111 selects the next column. After selecting the next column, the controller 111 can perform a key scan operation by repeating step 202 and its succeeding steps.

However, when the key matrix of FIG. 1 uses the key scan method of FIG. 2, there is a possible case in which the user simultaneously presses two or more different keys or successively presses two keys at very high speed. In either case, there is a possibility that two keys are simultaneously grounded. When that happens, the key scan method of FIG. 2 may fail to perform a correct key scan operation on the key input by the user for reasons described below.

Assuming that, with respect to FIG. 2, when the controller 111 checks a column of G-11, the user simultaneously presses two keys, the number '1' key and the number '2' key. The controller 111 outputs a value of '0' to the output port G-11 and a value of '1' to the output port G-12. Therefore, the port G-01, which is the row input terminal for both keys, effects the output to port G-11 and port G-12. That is, '0' is output to G-11 and '1' is output to G-12. A value of '0' should be input to G-01, however, it is determined through actual measurement that a value of neither '0' nor `1' is input to G-01. Therefore, the input port G-01 does not receive a value correctly matched to '1' but a value approximating '1', and conversely does not receive a value correctly matched to '0' but a value approximating '0'. Thus, in a certain case, the controller 111 may incorrectly determine that a '0' is input. This operation can cause the same result even when a key scan operation is performed on the port G-12.

Therefore, when the user simultaneously presses two or more keys or successively presses two different keys located in the same row very quickly, the controller 111 may fail to correctly detect the pressed keys. This problem inconveniences the user in using the mobile communication terminal.

It is, therefore, the object of the present invention to provide an apparatus and method for correctly detecting a key value input by a user in a mobile communication terminal.

This object is solved by the subject matter of the independent claims.

Preferred embodiments are defined in the dependent claims.

It is an aspect of the present invention to provide an apparatus and method for correctly detecting a key value input when a user simultaneously presses or successively presses keys located in the same row on key matrix logic in a mobile communication terminal.

It is another aspect of the present invention to provide an apparatus and method for correctly detecting a key input value without modification of a key matrix structure in a mobile communication terminal.

To achieve the above, there is provided an apparatus for detecting a key input signal in a mobile communication terminal including a plurality of keys constituting a key matrix structure having a plurality of rows, a plurality of columns, and a switch for connecting one of the rows to one of the columns. The apparatus comprises pull-up resisters for maintaining an input value of each row in the key matrix structure as a 'high' value; and a controller for connecting the columns and the rows to corresponding ports, designating the ports connected to the respective columns as input ports, designating the ports connected to the respective rows as input ports, and sequentially selecting the columns, thereby performing a key scan operation; and for changing a column selected during the key scan operation into an output port, outputting a 'low' value to the output port, and detecting a column to which the switch is connected among the columns connected to the rows, thereby detecting a key input signal.

To achieve the above, there is provided a method for detecting a key input signal in a mobile communication terminal including a plurality of keys constituting a key matrix structure having a plurality of rows, a plurality of columns, and a switch for connecting one of the rows to one of the columns, and including pull-up resisters for maintaining an input value of each row in the key matrix structure as a 'high' value. The method comprises the steps of: designating all ports connected to the rows and the columns as input ports; selecting one of a plurality of the columns, changing the selected column into an output port, and outputting a 'low' signal to the output port; performing key scan by checking a plurality of the keys; and changing a column selected after the key scan back into an input port.

The present invention will become more apparent from the following detailed description when taken in conjunction with the accompanying drawings in which:
FIG. 1 is circuit diagram illustrating a key matrix included in a general mobile communication terminal;
FIG. 2 is a flowchart illustrating a key scan operation in a general mobile communication terminal; and
FIG. 3 is a flowchart illustrating a process of detecting a key signal in a mobile communication terminal according to a preferred embodiment of the present invention.

A preferred embodiment of the present invention will now be described in detail with reference to the annexed drawings. In the following description, a detailed description of known functions and configurations incorporated herein has been omitted for conciseness.

Mobile communication terminals that may be used with the present invention include cellular phones, PCS (Personal Communications Service) phones, smart phones, PDAs (Personal Digital Assistant), or any terminal with a key matrix structure. The "key matrix structure" refers to the structure illustrated in FIG. 1, in which the controller 111 distinguishes rows from columns and detects a key input by a user through switches that connect rows to columns. A person skilled in the art can make key matrix structures similar to or modified from the structure of FIG. 1. Any such modified key matrix structures are within the scope of the present invention.

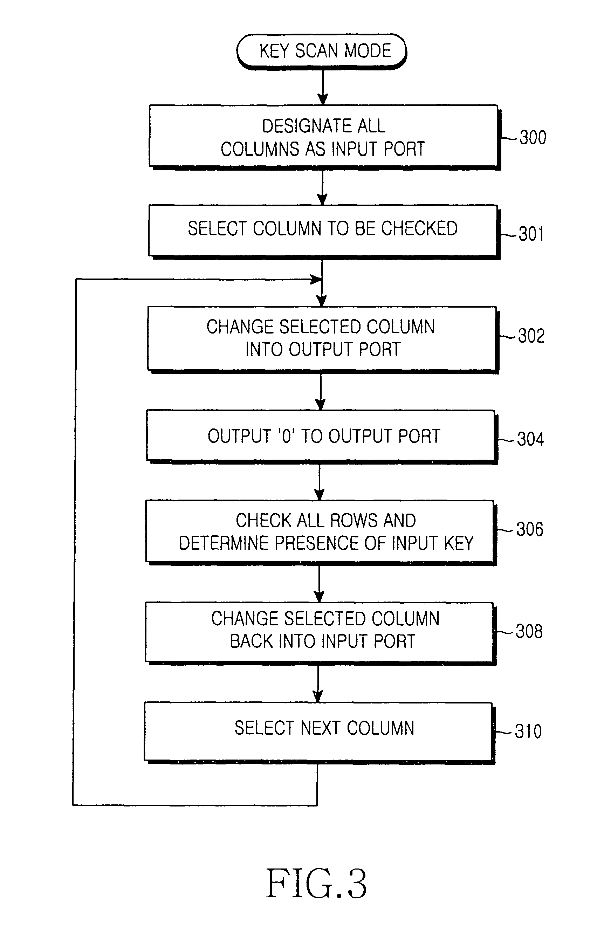

The key matrix utilized in the present invention is identical in structure to the key matrix of FIG. 1, except that the controller 111 has different input ports and output ports and thus has a different operation. A description will now be made of the change in input ports and output ports of the controller 111, and a description of the change in operation of the controller 111 will be made later with reference to FIG. 3.

The controller 111 designates all ports G-01, G-02, G-03 and G-04 connected to respective rows as input ports, and also designates all ports G-11, G-12, G-13 and G-14 connected to respective columns as input ports to start. Peripheral circuits of the proposed key matrix are similar in structure to those of the conventional prior art key matrix. That is, the connection between the pull-up resisters R and the power supply terminal Vcc is included.

Next, a description will be made of a structure and operation of the key matrix in which the controller 111 designates its input ports and output ports in the manner described above. FIG. 3 is a flowchart illustrating a process of detecting a key signal in a mobile communication terminal according to a preferred embodiment of the present invention.

Referring to FIG. 3, in step 300, the controller 111 designates all columns as input ports. Thereafter, in step 301, the controller 111 selects a column to be checked among the columns designated as input ports. The columns can be sequentially selected in the order described in the Related Art section. For example, the controller 111 can select their terminals in order of G-11 → G-12 → G-13 → G-14 → G-11 → G-12 → .... After selecting a column to be checked in this way, the controller 111 changes the selected column into an output port in step 302. Although all columns serve as output ports in the conventional key matrix, because all the output ports serve as input ports in the key matrix according to the present invention, the controller 111 should change an input port into an output port in order to perform a key scan operation on a corresponding column. If a port of the selected column is a port G-11, the controller 111 changes the port G-11 into an output port. Thereafter, in step 304, the controller 111 outputs a value of '0' to the changed output port G-11. In the case where the terminal G-11 is selected and then a key scan operation is performed, a value of '0' is output only to the terminal G-11 and the other ports all serve as input ports no matter whether they correspond to rows or columns.

After outputting a value of '0' to the column undergoing the key scan, the controller 111 checks all rows and determines whether there is an input key, in step 306. This will be described herein below by way of example. When a value of '0' is output through the port G-11, if the user inputs no key, there is no row connected to the column corresponding to the port G-11. Therefore, input ports G-01, G-02, G-03 and G-04 of the respective rows all have a High value. However, if a key of numeral 1 is input, the switch 121 corresponding to the numeral 1 connects the port G-01 to the port G-11. In this case, because the key scan is performed using the port G-11, the port G-11 outputs a value of '0', serving as a ground. Therefore, the port G-01 also serves as a ground, receiving a Low value. If a key of another column is simultaneously input together with the key of numeral 1, the corresponding port also receives a Low value as a key input.

Now, a description will be made of an operation performed when the user simultaneously inputs two or more different keys located in the same row or successively inputs the keys at high speed. It is assumed that key scan is performed on port G-11, and the 1 key and 2 key are pressed simultaneously. In this state, both the switch 121 corresponding to the 1 key and the switch 122 corresponding to the 2 key are connected. However, according to the present invention, port G-12 which is the column for 2 key is an input port. Therefore, no value is output to port G-12. Because a ground value of '0' is input to port G-11, the controller 111 can determine that numeral 1 is input. That is, the controller 111 can correctly detect the input value of key 1.

After checking a key input of the corresponding column, the controller 111 changes the selected column back into an input port in step 308. In this manner, errors from having different values output from different columns are prevented.

Thereafter, in step 310, the controller 111 selects the next column to be scanned. In doing so, the columns can be sequentially selected in the method described above, or according to a different order. After selecting the next column, the controller 111 can perform a key scan operation by repeating step 302 and its succeeding steps.

As can be understood from the foregoing description, the terminal having a key matrix structure according to an embodiment of the present invention can correctly detect a key input without error without modification of hardware logic.

While the invention has been shown and described with reference to a certain preferred embodiment thereof, it will be understood by those skilled in the art that various changes in form and details may be made therein without departing from the scope of the invention as defined by the appended claims.

## Claims

1. An apparatus for detecting a key input signal in a mobile communication terminal including a plurality of keys constituting a key matrix structure having a plurality of rows, a plurality of columns, and a switch for connecting one of the rows to one of the columns, the apparatus comprising:
pull-up resisters for maintaining an input value of each row in the key matrix structure as a 'high' value; and
a controller constructed and arranged to;
connect the columns and the rows to corresponding ports, designate the ports connected to the respective columns as input ports, designate the ports connected to the respective rows as input ports, and sequentially select the columns, thereby performing a key scan operation; and
change a column selected during the key scan operation into an output port, output a 'low' value to the output port, and detect a column to which the switch is connected among the columns connected to the rows, thereby detecting a key input signal.

2. The apparatus of claim 1, wherein when the key scan operation on a particular column is completed, the controller changes the corresponding column back into an input port.

3. A method for detecting a key input signal in a mobile communication terminal including a plurality of keys constituting a key matrix structure having a plurality of rows, a plurality of columns, and a switch for connecting one of the rows to one of the columns, and including pull-up resisters for maintaining an input value of each row in the key matrix structure as a 'high' value, the method comprising the steps of:
designating all ports connected to the rows and the columns as input ports;
selecting one of a plurality of the columns, changing the selected column into an output port, and outputting a 'low' signal to the output port;
performing key scan by checking a plurality of the keys; and
changing a column selected after the key scan back into an input port.

4. The method of claim 3, wherein the step of performing key scan comprises checking an input key by detecting a change in voltage value input from a plurality of the columns.
